# EUROPÄISCHE PATENTSCHRIFT

(11) **EP 0 668 938 B1**
(45) Veröffentlichungstag und Bekanntmachung des Hinweises auf die Patenterteilung: **04.09.1996**
(21) Anmeldenummer: 94900053.3
(22) Anmeldetag: 18.11.1993
(51) Int. Cl.: C23C 16/32, C23C 16/34, C23C 16/36, C23C 16/40

(54) **WERKZEUG UND VERFAHREN ZUR BESCHICHTUNG EINES WERKZEUGGRUNDKÖRPERS**
TOOL AND PROCESS FOR COATING A BASIC TOOL COMPONENT
OUTIL ET PROCEDE POUR LE REVETEMENT D'UN CORPS DE BASE D'OUTIL

(30) Priorität: 21.11.1992 DE 4239234
(43) Veröffentlichungstag der Anmeldung: 30.08.1995
(73) Patentinhaber: Widia GmbH, 45145 Essen (DE)
(72) Erfinder: VAN DEN BERG, Hendrikus, NL-5925 BT Venlo-Blerick (NL); KÖNIG, Udo, D-45149 Essen (DE); TABERSKY, Ralf, D-46240 Bottrop (DE)
(74) Vertreter: Vomberg, Friedhelm, Dipl.-Phys.
(86) Internationale Anmeldenummer: DE9301111
(87) Internationale Veröffentlichungsnummer: WO9412682

(56) Entgegenhaltungen:
- EP-A- 0 196 201
- EP-A- 0 440 157
- DE-C- 3 544 975
- US-A- 4 943 450
- US-A- 5 077 091

## Beschreibung

Die Erfindung betrifft ein Werkzeug aus einem Grundkörper aus Hartmetall, Cermet oder Stahl und einer auf dem Grundkörper aufgebrachten, aus Carbiden, Nitriden und/oder Carbonitriden des Titans und/oder des Zirkoniums und/oder Aluminiumoxid und sich aus dem CVD-Beschichtungsverfahren ergebenden Reststoffen bestehenden mehrlagigen Oberflächenbeschichtung.

Die Erfindung betrifft ferner ein Verfahren zur Beschichtung eines Grundkörpers aus Hartmetall, Cermet oder Stahl mit mehreren aus Carbiden, Nitriden und/oder Carbonitriden des Titans und/oder Zirkoniums und/oder Aluminiumoxids bestehenden Lagen mittels eines Abscheideverfahrens aus der Gasphase.

Bereits in der DE-Z "Angewandte Chemie", 69. Jahrgang, Nr. 9, Seiten 281 bis 312, 07. Mai 1957, wird beschrieben, daß die Sprödigkeit von Hartstoffen dadurch umgangen werden kann, daß man dieselben in Form von dünnen Oberflächenschichten anwendet, um andere Werkstoffe gegen mechanische oder chemische Beanspruchung zu schützen. So wird beispielsweise die Beschichtung eines Bleches mit einer 6 µm starken Schicht von TiN beschrieben.

Darüber hinaus ist beispielsweise aus der CH-PS 507 094 ein Formkörper bekannt, der aus einer Hartmetallunterlage und mindestens einer Hartstoffschicht besteht, wobei die Hartmetallunterlagen aus einem oder mehreren Hartstoffen und mindestens einem Bindemetall zusammengesetzt ist, und wobei die Hartstoffschicht harte Carbide oder Nitride enthält. Derartige Formkörper können für Werkzeuge der spanabhebenden und spanlosen Formgebung verwendet werden, da sie gute Verschleißeigenschaften besitzen. Die Körper werden nach dem CVD-Prozeß (chemical vapour deposition-Prozeß) hergestellt, wie er beispielsweise in der CH-PS 452 205 beschrieben ist. Der CVD-Prozeß gehört heute zu den gebräuchlichsten Beschichtungsverfahren und besteht darin, daß aus einer reaktiven Gasatmosphäre, die in der Regel eine Temperatur zwischen 900°C bis 1200°C hat, auf einem Substrat eine Oberflächenschicht abgeschieden wird. Dabei enthält die Gasatmosphäre mehrere Verbindungen, die bei der Reaktionstemperatur miteinander reagieren und den in der Oberflächenschicht vorhandenen Stoff bilden. Es ist heute allgemein üblich, metallische Substrate mit Hartstoffschichten aus Carbiden, Nitriden oder Carbonitriden zu überziehen, wobei die Gesamtatmosphäre Halogenide der Elemente der III- bis VI-Gruppe des Periodensystems und eine stickstoffhaltige Verbindung und eine kohlenstoffhaltige Verbindung enthalten. So wird auf einem Hartmetallgrundkörper eine Titancarbidschicht bei ca. 1000°C aus einer Gasatmosphäre abgeschieden, die Titantetrachlorid und Methan enthält. Als kohlenstoffhaltige Verbindungen werden insbesondere gasförmige Kohlenwasserstoffe verwendet, während als stickstoffhaltige Verbindungen N₂, NH₃ oder Amine zur Anwendung kommen.

Um bei niedrigen Abscheidetemperaturen arbeiten zu können, ist das sogenannte plasmaunterstützte CVD-Verfahren vorgeschlagen worden. Überlagert man dem Reaktionsgas in einer Niederdruckglimmentladung ein Nichtgleichgewichtsplasma, so werden die in dem Gas vorhandenen Ladungsträger unter dem Einfluß des bestehenden elektrischen Feldes beschleunigt. Abhängig von der Teilchendichte bzw. dem Druck bestimmt sich auch die freie Weglänge zwischen zwei Zusammenstößen. Reicht die Teilchenenergie bei der angelegten Spannung aus, können Moleküle oder Atome zur Dissozierung oder Ionisierung angeregt werden. Hierdurch werden chemische Reaktionen möglich, die ansonsten nur bei relativ höheren Temperaturen ablaufen könnten. Die Niederdruckplasmen können prinzipiell durch Anlegen einer konstanten Gleichspannung an einem als Kathode geschalteten Werkstück, durch eine hochfrequente Wechselspannung oder durch eine gepulste Gleichspannung erzeugt werden.

Die Hochfrequenzanregung, bei der die Energie induktiv oder kapazitiv von außen in das Reaktionsgefäß eingeführt werden kann, wird zur Abscheidung von sehr reinen Schichten in der Elektrotechnik, z.B. bei Mikrochips, häufig verwendet. Da es ohne direkt mit den Substraten verbundene Elektroden arbeitet, kommt es nicht darauf an, ob der Werkstoff selbst leitend oder nichtleitend ist. Nachteiligerweise ist dieses Verfahren sehr aufwendig.

Der einfachste Weg zur Erzeugung einer Niederdruckentladung ist der, das zu beschichtende Werkstück als Kathode zu schalten und den Rezipienten bzw. dessen Wände als Anode bzw. Erdpotential zu benutzen. Die Substrattemperatur ist hierbei eine Funktion der Spannung und des Stromes.

Weiterhin kann die Gleichspannung gepulst werden, wobei die Substrattemperatur eine Funktion der Peak-Spannung sowie des Peak-Stromes als auch der Pulsdauer und Pulsfrequenz ist. Vorteilhafterweise kann bei diesem Verfahren die Beschichtungstemperatur unabhängig von den Niederdruckentladungsparametern, der Spannung und dem Strom eingestellt werden.

In der WO 92/05009 sowie der WO 92/05296 wird auch bereits ein Schneidwerkzeug vorgeschlagen, dessen Oberflächenbeschichtung aus mehreren Lagen besteht, wobei die ersten Schichten durch CVD-Verfahren und die äußere Schicht durch ein PVD-Verfahren aufgetragen worden sind. Der Nachteil dieser Verfahrenstechnik besteht darin, daß PVD- und CVD-Beschichtungen in verschiedenen Anlagen aufgetragen werden müssen, was voraussetzt, daß die Werkzeuge nach der CVD-Beschichtung in eine andere Anlage transferiert werden müssen, bevor die PVD-Schicht aufgetragen werden kann. Hierzu sind jeweils neue Aufheizvorgänge notwendig, was den bei der Herstellung der Gesamtbeschichtung zu leistenden Energieaufwand beträchtlich erhöht. Darüber hinaus haben praktische Erfahrungen gezeigt, daß die maximale Dicke der Gesamtbeschichtung auf 10 bis 15 µm bei nach dem Stand der Technik bekannten Beschichtungen begrenzt ist.

In der JP-59-25970-A wird ein beschichteter Hartmetallkörper beschrieben, dessen Beschichtung aus mehreren Lagen besteht. Die innere Schicht soll aus ein oder zwei Lagen aus Titancarbid, Titannitrid oder Carbonitrid sowie SiC oder Si₃N₄ und die äußere Schicht aus Al₂O₃ bestehen. Die unterhalb der genannten Al₂O₃-Schicht liegenden Schichten sollen mittels CVD aufgetragen werden, während die Al₂O₃-Schicht wechselweise mittels Plasma-CVD- und CVD-Beschichtung aufgetragen werden soll, wobei amorphes Al₂O₃ oder eine Mischschicht von amorphem Al₂O₃ und kristallinem Al₂O₃ sowie eine Schicht aus kristallinem Al₂O₃ erhalten werden. Auch diese Beschichtung zeigte keine ausreichende Haftfestigkeit auf dem Hartmetall-Substratkörper.

Es ist daher Aufgabe der vorliegenden Erfindung, ein Werkzeug der eingangs genannten Art anzugeben, das aufgrund der physikalischen Eigenschaften der einzelnen aufgetragenen Schichten, jeweils sowohl für sich alleine als auch in Verbindung mit den übrigen benachbarten Schichten eine gleichmäßige, verschleißfeste Oberflächenbeschichtung aufweist, die bei Belastung keine Absplitterungserscheinungen zeigt.

Es ist ferner Aufgabe der Erfindung, ein Verfahren der eingangs genannten Art anzugeben, mit dem eine große Gesamtdicke der Beschichtung von bis zu 30 µm, möglichst bei günstiger Wachstumsgeschwindigkeit der Einzelschichten erzielt werden kann.

Der erste Teil der Aufgabe wird durch das im Anspruch 1 beschriebene Werkzeug gelöst, das neuerungsgemäß dadurch gekennzeichnet ist, daß die an den Grundkörper angrenzende erste einzelne Lage durch ein durch Glimmentladung aktiviertes CVD-Verfahren (PCVD) aufgebracht worden ist und daß die weiteren Oberflächenschichten aus mehreren in abwechselnder Folge durch ein thermisches CVD-Verfahren und durch ein durch Glimmentladung aktiviertes CVD-Verfahren (PCVD) aufgetragenen Lagen besteht. Da durch PCVD-Verfahren aufgetragene Schichten sehr feinkörnig und dicht gepackt sind, wird die erste an den Grundkörper angrenzende Lage durch ein durch Glimmentladung aktiviertes CVD-Verfahren aufgebracht, womit eine Diffusionssperre zwischen dem Grundkörper und den weiteren Oberflächenschichten geschaffen wird. Erfahrungen haben gezeigt, daß aufgrund der unterschiedlichen in einer durch CVD einerseits gebildeten Lage und einer durch PCVD gebildeten Lage andererseits besonders dicke und verschleißbeständige Schichten ausgebildet werden können. Sowohl CVD- als auch PCVD-Verfahren haben darüber hinaus hohe Wachstumsraten, so daß das Werkzeug wegen der entsprechend kurzen Beschichtungszeiten auch preisgünstiger herstellbar ist. Die gewählte Schicht- bzw. Lagenfolge hat eine große mechanische Stabilität bei einer überraschend guten Biegefestigkeit (auch bei großen Gesamtschichtdicken oberhalb von 20 µm). Darüber hinaus liefern Lagen, die mittels PCVD aufgetragen worden sind, günstige Wachstumsbedingungen für nachfolgende CVD-Lagen, die besonders feinkörnig und dicht sind.

Weiterbildungen des erfindungsgemäßen Werkzeuges sind in den Ansprüchen 2 bis 6 beschrieben.

So beträgt die Gesamtdicke der Beschichtung 2 bis 40 µm, wobei jede einzelne Lage eine Mindestdicke von 0,2 µm aufweist. Vorzugsweise enthalten die durch ein durch Glimmentladung aktiviertes CVD-Verfahren aufgetragenen einzelnen Lagen neben den Elementen Titan, Zirkon, Aluminium, Kohlenstoff, Stickstoff und/oder Sauerstoff ein Halogenelement in einer Konzentration von 0,1 bis 3 % Stoffmenge.

Es ist sowohl möglich, daß die durch CVD- und PCVD-Verfahren in abwechselnder Folge aufgetragenen einzelnen Lagen aus denselben Hartstoffen bestehen, insbesondere Titannitrid, als auch daß die einzelnen Lagen aus verschiedenen Hartstoffen bestehen. Nach einer weiteren Ausführungsform der Erfindung bestehen die durch CVD- und PCVD-Verfahren aufgetragenen einzelnen Lagen aus mehreren verfahrensgleichen Einzelschichten, nämlich Paketen aus verschiedenen Hartstoffen, wie z.B. TiN, Ti(C,N), TiC, Zr(C,N), Al₂O₃.

Vorzugsweise hat die durch PCVD-Verfahren aufgetragene Lage bzw. haben die aufgetragenen Lagen eine mindestens um den Faktor 2 kleinere mittlere Korngröße als die der durch CVD-Verfahren aufgetragenen Lagen haben. Insbesondere soll die Dicke der Gesamtschicht mehr als 15 µm betragen.

Die auf das Verfahren bezogene Aufgabe wird durch die Maßnahmen nach Anspruch 7 gelöst. Diese Verfahrensführung besitzt den Vorteil, daß hohe Wachstumsraten beim Schichtaufbau als auch gleichermaßen feinkörnige und dichte einzelne Lagen geschaffen werden können. Insbesondere liefern PCVD-Lagen besonders günstige Wachstumsbedingungen für CVD-Lagen, die sich dann sehr feinkörnig und dicht auftragen lassen.

Weiterbildungen des erfindungsgemäßen Verfahrens sind in den Ansprüchen 8 bis 10 beschrieben. So wird nach einer besonderen Ausgestaltungsform des Verfahrens eine gepulste Gleichspannung mit einer in den Pulspausen verbleibenden Restgleichspannung einer Größe gleich oder oberhalb des niedrigsten Ionisierungspotentials der beteiligten Gase des PCVD-Prozesses an dem als Kathode geschalteten Schneideinsatzgrundkörper angelegt. Diese Restgleichspannung sollte jedoch 50 % des Maximalwertes der gepulsten Gleichspannung nicht überschreiten.

Die gepulste Gleichspannung ist im Regelfall eine Rechteckspannung mit einer maximalen Amplitude zwischen 200 und 900 Volt und einer Periodendauer zwischen 20 µs und 20 ms. Abweichungen unter Ausbildung von nicht senkrechten Anstiegs- und Abfallflanken sowie Dachschrägen sind jedoch ebenso denkbar, sofern die Bedingung erfüllt bleibt, daß zwischen zwei maximalen Spannungswerten die Gleichspannung nicht auf Null sinkt, sondern stets oberhalb des niedrigsten Ionisierungspotentials der beteiligten Gase und unterhalb von 50 % der maximalen Spannungsauslenkung bleibt. Nach einer Weiterbildung der Erfindung liegt das Verhältnis der Pulslänge (Dauer des Spannungssignals eines Pulses) zu der Periodendauer (Pulslänge + Pulspausenlänge) zwischen 0,1 bis 0,6. Bei Abscheidetemperaturen zwischen 400°C und 700°C sollte die Schichtwachstumsgeschwindigkeit zwischen 0,5 bis 10 µm/h liegen.

Nähere Ausführungen hierzu sind unter anderem in der DE 38 41 731 A1 und der EP 0 373 412 A1 beschrieben, worauf hiermit verwiesen wird.

Vorzugsweise wird das Plasma-CVD-Verfahren bei Temperaturen oberhalb von 300°C und Drücken unter 10000 Pa durchgeführt, wobei in einem den oder die Substratkörper allseitig umhüllenden Käfig auf der dem Substratkörper zugewandten Innenfläche ein angrenzender Glimmsaum erzeugt wird, während ein zur Bildung der Hartstoff-Beschichtung geeignetes reaktives Gasgemisch durch den Käfiginnenraum geleitet wird. Im wesentlichen bildet somit der zu beschichtende Substratkörper das Zentrum des Käfigs. Insbesondere wird dieses Zentrum durch einen sich kugelsymmetrisch umhüllenden Glimmsaum umgeben. Der Käfig verhindert auch eine bevorzugte Strömungsrichtung der reagierenden Gase bzw. einen bevorzugten Ort des Niederschlages der Reaktionsprodukte als Beschichtung. Durch die Käfigstruktur wird insbesondere das Problem gelöst, das Reaktionsgas über den ganzen Käfiginnenraum gleichmäßig zu verteilen.

Der Substratkörper kann entweder elektrisch isoliert und potentialfrei in dem Käfig angeordnet sein oder mit dem als Anode wirkenden Reaktor (Gefäß) elektrisch leitend verbunden sein, etwa dergestalt, daß das Substrat und das Reaktorgefäß auf Massepotential gelegt werden. Eine weitere Möglichkeit ist dadurch gegeben, den Substratkörper mit der den Glimmsaum am Käfig erzeugenden Spannungsquelle elektrisch leitend zu verbinden, d.h., das Substrat auf das Kathodenpotential (des Käfigs) zu legen.

Nach einer weiteren Variante der Erfindung kann auch eine von der Spannungsquelle des Käfigs unabhängige zweite Spannungsquelle an dem Substratkörper anliegen und ein vom Käfigpotential unabhängiges Potential erzeugen.

Vorzugsweise wird die Glimmentladung auf den Innenflächen des Käfigs durch einen gepulsten Gleichstrom erzeugt, die insbesondere die in der DE 38 41 731 beschriebene Charakteristik aufweisen kann. Der Substratkörper wird auf Temperaturen von maximal 1100°C erhitzt, vorzugsweise sollte die Temperatur jedoch zwischen 400 bis 900°C, weiterhin vorzugsweise zwischen 600°C und 800°C liegen. Die eingestellten Drücke sollten mindestens 100 Pa bis 1000 Pa in dem Reaktionsgefäß betragen.

Die herkömmlichen CVD-Verfahren sind im Prinzip nach dem Stand der Technik bekannt und werden bei Substrattemperaturen von 900°C und mehr durchgeführt. Hinweise zu Literaturstellen, in denen diese CVD-Verfahren beschrieben werden, finden sich beispielsweise in der WO 92/05009.

Nach einer weiteren Ausgestaltung der Erfindung werden die einzelnen Lagen in einer Hitze ohne zwischenzeitliche Abkühlung des Substrats aufgetragen. Vorzugsweise werden die zuvor beschriebenen Werkzeuge bzw. die nach dem Verfahren hergestellten Gegenstände als Schneideinsätze zum Drehen, Fräsen, Bohren sowie Gewindeschneiden verwendet.

Im folgenden wird ein Ausführungsbeispiel der Erfindung beschrieben.

Zur Beschichtung von Wendeschneidplatten, die zum Drehen von Stahlteilen verwendet werden sollen, werden in einem Beschichtungsofen, der sowohl für die Durchführung des CVD-Verfahrens als auch für die des PCVD-Verfahrens geeignet ist, 400 Wendeschneidplatten der Ausführung CNMG120412 (Bezeichnung DIN 4987) chargiert. Die Wendeschneidplatten waren von käfigartigen Konstruktionen umgeben und konnten gemeinsam als Kathode geschaltet werden. Nach dem Aufheizen auf 780°C wurde der plasmachemische Prozeß zur Abscheidung von Titannitrid in Gang gesetzt. Dabei wurden folgende Beschichtungsparameter eingestellt (PCVD Schritt):

| | |
|---|---|
| Temperatur: | 780°C |
| Druck der reaktiven Gasatmosphäre: | 3 mbar |
| Gasgemisch: | 1,5 % TiCl₄, 11,5 % N₂, 8 % Ar, 79 % H₂ |
| Maximale Pulsspannung: | 580 V |
| Dauer des Strompulses: | 75 µs |
| Dauer der Pause: | variabel von 110 bis 150µs |
| Mittlere Restspannung zwischen den Strompulsen: | ca. 20 V |

Die Temperatur wurde sehr genau durch die Länge der Pulspause geregelt. Eine schnelle elektronische Regelung erhöhte die Pulspausenzeit bei einem Temperaturanstieg oder erniedrigte sie bei einem Temperaturabfall. Nach 90 Minuten wurde dieser Prozeß beendet und die Temperatur durch eine äußere Heizvorrichtung erhöht. Daraufhin wurde der CVD-Beschichtungsschritt eingeleitet, bei dem folgende Werte eingestellt wurden:

| | |
|---|---|
| Temperatur: | 940°C |
| Druck der reaktiven Gasatmosphäre: | 250 mbar |
| Gasgemisch: | 2,5 % TiCl₄, 35 % N₂, 62,5 % H₂ |

Nach einer Zeitdauer von 120 Minuten wurde dieser Prozeß beendet. Hierauf wurden erneut die obengenannten Parameter des PCVD-Schrittes eingestellt und eine PCVD-Beschichtung durchgeführt. Insgesamt wurden die Prozeßschritte PCVD und CVD dreimal aneinandergereiht. Die äußerste Einzelschicht war somit eine durch CVD hergestellte TiN-Schicht. Nach der Abkühlung und der öffnung des Ofens wurden aus verschiedenen Bereichen der Beschichtungskammer Proben entnommen und genau untersucht. Metallographische Feinschnitte zeigten, daß die Beschichtung aus sechs Lagen bestand. Dabei wiesen die CVD-Schichten eine etwas andere Farbschattierung als die PCVD-Lagen auf, obwohl alle Lagen aus TiN bestanden (Grundfarbe gelb). Dies ist auf die unterschiedliche Kornstruktur der CVD- und PCVD-Schichten zurückzuführen. Eine eingehende Untersuchung mit einem Rasterelektronenmikroskop zeigte, daß die mittlere Korngröße der PCVD-Lagen mindestens um einen Faktor 2 kleiner ist als die der CVD-Lagen. Die farblichen Unterschiede der CVD- und PCVD-Schichten ermöglichen ein Ausmessen der Teilschichtdicken. Im Mittel betrugen die Dicken der CVD-Schichten etwa 5 µm und die der PCVD-Schichten etwa 3 µm. Insgesamt schwankte die Gesamtschichtdicke der genommenen Proben zwischen 22 und 27 µm. Laboruntersuchungen mit Hilfe eines Diamant-bestückten Ritztestgerätes zeigten eine außergewöhnlich mechanische Stabilität der Beschichtung.

Andere Wendeschneidplatten aus dem beschriebenen Beschichtungsversuch wurden in industrieller Fertigungspraxis getestet. Beispielsweise wurden geschmiedete Achszapfen von 220 mm Länge und einem maximalen Durchmesser von 85 mm aus dem Stahlwerkstoff 1.1213 mit einer Zugfestigkeit von 700 bis 800 N/mm² bearbeitet. Beim Drehen der Teile auf einer automatischen Drehmaschine wurden folgende Arbeitswerte angewendet: Schnittiefe: 2 bis 3 mm, Vorschub: 0,45 mm/Umdrehung und Schnittgeschwindigkeit: 250 bis 270 m/min. Die Schwankungsbreite dieser Schnittdaten wurde durch die kegelförmige Gestalt des zu bearbeitenden Teiles verursacht. Bei diesem Arbeitsvorgang wurden bislang Wendeschneidplatten der Grundform CNMG120412 aus einem Hartmetall der Zerspanungsanwendungsklasse P15 (Bezeichnung nach DIN/ISO 4990) eingesetzt, die durch CVD mit einer Beschichtung aus drei Lagen aus Titancarbid, Titancarbonitrid und Titannitrid versehen waren. Die Gesamtdicke dieser Beschichtung betrug etwa 12 µm. In dieser Ausführung konnten pro Wendeschneidplatte 220 bis 230 Werkstücke bearbeitet werden, bevor ein Austausch notwendig wurde. Frühere Versuche, die Verschleißbeständigkeit dieser CVD-beschichteten Wendeschneidplatte durch die Vergrößerung der Schichtdicke zu erhöhen, führten nicht zum Erfolg, da bei mit sehr dicken CVD-Schichten (Schichtdicke ca. 18 bis 20 µm) versehenen Wendeschneidplatten die Schneidkanten unter der Belastung des Schneidprozesses bröckelten. Erst der Einsatz einer wie oben beschriebenen erfindungsgemäßen, mit einer ca. 24 µm dicken Beschichtung versehenen Wendeschneidplatte konnte das Fertigungsergebnis wesentlich erhöhen. Nach der Bearbeitung von 200 Werkstücken konnten noch keine Bröckelungen oder Ausbrüche an der Schneidkante festgestellt werden. Die erfindungsgemäß beschichteten Wendeschneidplatten erreichten das Standzeitende erst nach der Bearbeitung von 480 bis 530 Teilen.

## Patentansprüche

1. Werkzeug aus einem Grundkörper aus Hartmetall, Cermet oder Stahl und einer auf dem Grundkörper aufgebrachten, aus Carbiden, Nitriden und/oder Carbonitriden des Titans und/oder des Zirkoniums und/oder Aluminiumoxid und sich aus dem CVD-Beschichtungsverfahren ergebenden Reststoffen bestehenden mehrlagigen Oberflächenbeschichtung.
**dadurch gekennzeichnet,**
daß die an den Grundkörper angrenzende erste einzelne Lage durch ein durch Glimmentladung aktiviertes CVD-Verfahren (PCVD) aufgebracht worden ist und daß die weiteren Oberflächenschichten aus mehreren in abwechselnder Folge durch ein thermisches CVD-Verfahren und durch ein durch Glimmentladung aktiviertes CVD-Verfahren (PCVD) aufgetragenen Lagen besteht.

2. Werkzeug nach Anspruch 1, dadurch gekennzeichnet, daß die gesamte Dicke der Beschichtung 2 bis 40 µm beträgt und/oder jede einzelne Lage dicker als 0,2 µm ist.

3. Werkzeug nach Anspruch 1 oder 2, dadurch gekennzeichnet, daß die durch Glimmentladung aktiviertes CVD-Verfahren aufgetragenen einzelnen Lagen neben den Elementen Titan, Zirkon, Aluminium, Kohlenstoff, Stickstoff und/oder Sauerstoff ein Halogenelement in einer Konzentration von 0,1 bis 3 % Stoffmenge enthalten.

4. Werkzeug nach Ansprüchen 1 bis 3, dadurch gekennzeichnet, daß die durch CVD- und PCVD-Verfahren in abwechselnder Folge aufgetragenen einzelnen Lagen aus denselben Hartstoffen, vorzugsweise aus Titannitrid oder daß die durch die CVD- und PCVD-Verfahren in abwechselnder Folge aufgetragenen einzelnen Lagen aus verschiedenen Hartstoffen bestehen.

5. Werkzeug nach einem der Ansprüche 1 bis 3, dadurch gekennzeichnet, daß die durch CVD- und PCVD-Verfahren aufgetragenen einzelnen Lagen aus mehreren verfahrensgleichen Einzelschichten, nämlich Paketen aus verschiedenen Hartstoffen, bestehen.

6. Werkzeug nach einem der Ansprüche 1 bis 5, dadurch gekennzeichnet, daß die durch PCVD aufgetragenen Lagen eine mindestens um den Faktor 2 kleinere mittlere Korngröße als die der durch CVD aufgetragenen Lagen haben und/oder daß die Dicke der Gesamtschicht mehr als 15 µm beträgt.

7. Verfahren zur Beschichtung eines Grundkörpers aus Hartmetall, Cermet oder Stahl mit mehreren aus Carbiden, Nitriden und/oder Carbonitriden des Titans und/oder Zirkoniums und/oder Aluminiumoxid bestehenden Lagen mittels eines Abscheideverfahrens aus der Gasphase, dadurch gekennzeichnet, daß in abwechselnder Folge einzelne Lagen mittels eines im Prinzip nach dem Stand der Technik bekannten CVD-Verfahrens und eines durch Glimmentladung aktivierten CVD-Verfahrens dem sogenannten Plasma-CVD-Verfahren aufgetragen werden, wobei die erste Lage eine Plasma-CVD-Lage ist.

8. Verfahren nach Anspruch 7, dadurch gekennzeichnet, daß die Plasmaaktivierung an dem als Kathode geschalteten Schneideinsatzgrundkörper durch eine gepulste Gleichspannung herbeigeführt wird.

9. Verfahren nach einem der Ansprüche 7 oder 8, dadurch gekennzeichnet, daß bei Temperaturen oberhalb von 300°C und Drücken unter 10000 Pa in einem den oder die Substratkörper allseitig umhüllenden Käfig auf der dem Substratkörper zugewandten Innenfläche ein Glimmsaum erzeugt wird, während ein zur Bildung der Hartstoffbeschichtung geeignetes reaktives Gasgemisch durch den Käfiginnenraum geleitet wird.

10. Verfahren nach Anspruch 9, dadurch gekennzeichnet, daß der Substratkörper elektrisch isoliert in dem Käfig angeordnet wird oder daß der Substratkörper mit dem als Anode wirkenden Reaktionsgefäß oder mit der den Glimmsaum am Käfig erzeugenden Spannungsquelle elektrisch leitend verbunden ist.

11. Verfahren nach einem der Ansprüche 7 bis 10, dadurch gekennzeichnet, daß die einzelnen Lagen in einer Hitze ohne zwischenzeitlicher Abkühlung des Substrates aufgebracht werden.

## Claims

1. A tool having a base body of hard metal, cermet, or steel and applied to the base body a multilayer surface coating comprised of carbides, nitrides and/or carbonitrides of titanium and/or zirconium and/or aluminum oxide and residual materials resulting of the CVD-coating process, characterized in that the first individual layer is applied to the base body by a glow-discharge activated CVD (PCVD) method and the further layers are applied alternately by a thermal CVD method and a glow-discharge activated CVD (PCVD) method.

2. The tool according to claim 1, characterized in that the overall thickness of the layers is between 2 and 40 µm and/or each individual layer is thicker than 0,2 µm.

3. The tool according to claim 1 or 2, characterized in that the individual layers applied by the glow-discharge activated CVD method have in addition to the elements titanium, zirconium, aluminum, carbon, nitrogen and/or oxygen a halogen element in a concentration of 0,1 to 3 % by weight.

4. The tool accoding to claims 1 to 3, characterized in that the individual layers applied alternately by the CVD and PCVD methods consist of the same hard materials, preferably of titanium nitride or that the individual layers applied alternately by the CVD and PCVD methods consist of different hard materials.

5. The tool according to one of claims 1 to 3, characterized in that the individual layers applied by the CVD and PCVD methods consist of individual layers produced by the same method, namely packs of different hard materials.

6. The tool according to one of claims 1 to 5, characterized in that the layers applied by the PCVD method have a particle size that is smaller by at least a factor of two than the layers applied by the CVD method and/or that the thickness of the overall layer is more than 15 µm.

7. A method of plating a base body of hard metal, cermet or steel with several layers of carbides, nitrides, and/or carbonitrides of titanium and/or zirconium and/or aluminum oxide by means of a gas-phase deposition method,
characterized in that individual layers are applied alternately by using the known CVD method and a glow discharge activated method, the so-called plasma CVD method, the first layer being a plasma CVD layer.

8. The method according to claim 7, characterized in that the plasma activation on the cutting-insert base body connected as a cathode is effected by a pulsed direct-current voltage.

9. The method according to one of claims 7 or 8,
characterized in that at temperatures above 300°C and pressures under 10.000 Pa in a cage completely surrounding the substrate body or bodies a glow edge is produced on the inner surface turned toward the substrate body, while a gas mixture intended to form the hard-material layer is conducted through the interior of the cage.

10. The method according to claim 9, characterized in that the substrate body is electrically insulated in the cage or that the substrate body is electrically conductively connected with the reaction container serving as anode or with the voltage source producing the glow edge on the cage.

11. The method according to one of claim 7 to 10,
characterized in that the individual layers are applied in one heat without intermediate cooling of the substrate.

## Revendications

1. Outil se composant d'un corps de base en métal dur, en cermet ou en acier et d'un revêtement de surface à plusieurs couches qui est appliqué au corps de base et qui se compose de carbures, de nitrures et/ou de carbonitrures du titane et/ou du zirconium et/ou d'oxyde d'aluminium ainsi que de substances résiduelles resultant du procédé CVD de revêtement
**caractérisé par le fait**
que la première couche individuelle contiguë au corps de base a été appliquée par un procédé CVD (PCVD) activé par une décharge lumineuse et que les autres couches de surface se composent de plusieurs couches appliquées de manière alternante par un procédé CVD thermique et par un procédé CVD (PCVD) activé par une décharge lumineuse.

2. Outil selon la revendication 1, caractérisé par le fait que l'épaisseur totale du revêtement est comprise entre 2 et 40 µm et/ou que chacune des couches présente une épaisseur supérieure à 0,2 µm.

3. Outil selon la revendication 1 ou 2, caractérisé par le fait que les couches individuelles appliquées par le procédé CVD activé par une décharge lumineuse contiennent outre les éléments tels que le titane, le zirconium, l'aluminium, le carbone, l'azote et/ou l'oxygène également un élément de halogène en une concentration de 0,1 à 3 % de quantité de matière.

4. Outil selon les revendications 1 à 3, caractérisé par le fait que les couches individuelles appliquées de manière alternante par les procédés CVD et PCVD se composent toutes des mêmes matériaux durs, de préférence de nitrure de titane, ou que les couches individuelles appliquées de manière alternante par les procédés CVD et PCVD se composent de matériaux durs différents.

5. Outil selon l'une des revendications 1 à 3, caractérisé par le fait que les couches individuelles appliquées par les procédés CVD et PCVD se composent de plusieurs couches particulières produites par le biais du même procédé, à savoir de paquets composés de matériaux durs différents.

6. Outil selon l'une des revendications 1 à 5, caractérisé par le fait que les couches appliquées par le procédé PCVD présentent une grosseur de grains moyenne qui est plus petite du moins du facteur 2 que celle des couches appliquées par le biais du procédé CVD et/ou que l'épaisseur de l'ensemble de la couche est supérieure à 15 µm.

7. Procédé pour le revêtement d'un corps de base en métal dur, en cermet ou en acier de plusieurs couches se composant de carbures, de nitrures et/ou de carbonitrures du titane et/ou du zirconium et/ou d'oxyde d'aluminium, au moyen d'un procédé de déposition de la phase gazeuse, caractérisé par le fait que des couches individuelles sont appliquées de manière alternante par le biais d'un procédé CVD en principe connu selon l'art antérieur et d'un procédé CVD activé par une décharge lumineuse, appelé couramment procédé CVD à plasma, la première couche étant une couche CVD à plasma.

8. Procédé selon la revendication 7, caractérisé par le fait que l'activation par plasma sur le corps de base d'insert de coupe, qui est connecté en tant que cathode est effectuée par le biais d'une tension continue pulsée.

9. Procédé selon l'une des revendications 7 ou 8, caractérisé par le fait qu'une zone réalisée par décharge lumineuse est produite dans une cage qui enveloppe le corps substrat ou bien les corps substrats de tout côté, sur la surface intérieure tournée vers le corps substrat, à des températures supérieures à 300°C et à des pressions inférieures à 10000 Pa, tout en conduisant au travers de l'intérieur de ladite cage un mélange de gaz réactif approprié à la formation du revêtement en matériau dur.

10. Procédé selon la revendication 9, caractérisé par le fait que le corps substrat est disposé dans la cage de manière à être électriquement isolé ou que le corps substrat est relié de manière électriquement conductrice avec le récipient de réaction faisant fonction d'anode ou avec la source de tension produisant ladite zone de décharge lumineuse sur la cage.

11. Procédé selon l'une des revendications 7 à 10, caractérisé par le fait que les couches individuelles sont appliquées en présence d'une chaleur sans refroidissement intermédiaire du substrat.
